# FASCICULE DE BREVET EUROPEEN

(11) **EP 2 260 314 B1**
(45) Date de publication et mention de la délivrance du brevet: **17.03.2021**
(21) Numéro de dépôt: 09729527.3
(22) Date de dépôt: 27.03.2009
(51) Int. Cl.: G01R 31/374, G01R 31/36

(54) **EQUIPEMENT DE RELEVE ET DE TRANSMISSION DE VALEURS MESUREES DE GRANDEURS PHYSIQUES, ET CAPTEUR DE MESURE POUR UN TEL EQUIPEMENT**
AUSRÜSTUNG ZUR AUFZEICHNUNG UND ÜBERTRAGUNG VON MESSWERTEN PHYSIKALISCHER GRÖSSEN SOWIE MESSSENSOR FÜR DERARTIGE AUSRÜSTUNG
EQUIPMENT FOR LOGGING AND TRANSMITTING MEASURED VALUES OF PHYSICAL QUANTITIES, AND MEASUREMENT SENSOR FOR SUCH EQUIPMENT

(30) Priorité: 02.04.2008 FR 0801823
(43) Date de publication de la demande: 15.12.2010
(73) Titulaire: SUEZ Groupe, 92040 Paris la Défense Cedex (FR)
(72) Inventeur: BORLEE, Jean-Paul, F-91440 Bures sur Yvette (FR)
(74) Mandataire: IPAZ
(86) Numéro de dépôt international: PCT/FR2009/000344
(87) Numéro de publication internationale: WO 2009/125095

(56) Documents cités:
- FR-A1- 2 884 321
- JP-A- H08 124 067
- JP-A- 2005 172 553
- US-A1- 2007 029 974
- US-A1- 2007 046 261
- US-A1- 2009 018 785
- US-B1- 6 532 425

## Description

L'invention est relative à un équipement de relevé et de transmission de valeurs mesurées de grandeurs physiques, du genre de ceux qui comprennent :
- au moins un capteur de mesure autonome, alimenté par une pile électrique, comportant un émetteur propre à transmettre à différents instants au moins une valeur mesurée par le capteur,
- et un récepteur pour recueillir les valeurs transmises par l'émetteur.

L'invention concerne plus particulièrement, mais non exclusivement, un tel équipement pour la télé-relève de compteurs de fluides, notamment de compteurs d'eau, comme exposé dans la demande de brevet FR n° 2 904 688, déposée le 04 août 2006 sous n° 06 07161, et publiée le 08 février 2008. La demande de brevet US 2007/046261 décrit un équipement de commande, qui est alimenté en énergie par une batterie. Pour prédire la durée de vie de cette batterie, on mesure la tension à l'aide d'un circuit à des instants successifs. Lorsque le gradient de tension (baisse de tension sur une période donnée) dépasse une valeur prédéterminée, un signal est produit. Pour améliorer la précision de la prédiction, la température est prise en compte notamment à l'aide d'une thermistance. Les valeurs de température sont enregistrées. La tension de la batterie est prise en compte pour une température prédéterminée, et les gradients de tension de batterie sont établis pour cette valeur prédéterminée de température. Si le gradient de tension dépasse la valeur prédéterminée, l'information est transmise par une unité de communication, à un centre éloigné. L'unité de communication ne transmet pas au centre éloigné des valeurs de température servant à estimer la durée de vie de la pile. Selon le document, la prédiction de durée de vie de la batterie est fondée sur une mesure de la tension de cette batterie, et sur la diminution de cette tension.

L'invention s'applique en particulier aux capteurs de mesure communiquant vers un récepteur, formant site central, par tout moyen de transmission approprié, en particulier par radiofréquence ou dispositif filaire.

Pour le maintien en état de fonctionnement d'un tel équipement de relevé et de transmission de valeurs mesurées, il convient d'assurer une bonne maintenance du capteur de mesure, essentiellement en remplaçant le capteur avant que sa pile électrique d'alimentation ne soit défaillante.

Actuellement, les piles utilisées pour ce genre d'application, notamment les piles au lithium, peuvent avoir des durées de vie de 15 ans et plus pour l'alimentation des circuits électroniques, mais cette durée est fortement variable, notamment en fonction des températures subies tout au long de la vie du capteur. Pour réduire les risques de panne du capteur de mesure par épuisement de la pile, les fabricants de piles ont généralement tendance à sous-évaluer la durée de vie, et à sur-dimensionner les piles pour une application donnée. Les exploitants ont généralement tendance à remplacer prématurément les capteurs avec leurs piles, à titre préventif.

Il en résulte des coûts d'exploitation relativement élevés.

L'invention a pour but, surtout, d'améliorer les conditions d'exploitation et la maintenance d'un équipement de relevé et de transmission de valeurs mesurées de grandeurs physiques.

Selon l'invention, un équipement de relevé et de transmission, selon la revendication 1, est proposé, dans lequel:
- le capteur comporte un moyen de mesure de la température au voisinage de la pile,
- une liaison est prévue pour fournir à l'émetteur les valeurs de température mesurées, lequel émetteur est prévu pour transmettre, outre les valeurs d'au moins une grandeur physique, ces valeurs de température mesurées, à intervalles déterminés,
- et le récepteur est prévu pour stocker les valeurs de température mesurées, estimer la durée de vie de la pile en tenant compte de ces valeurs mesurées, et déterminer une date de remplacement de cette pile.

Selon l'invention, le récepteur est prévu pour établir un profil de température de la pile en fonction du temps, et comporte un moyen de comparaison du profil de température relevé avec des profils types pour estimer la durée de vie probable de la pile.

De préférence, le récepteur comporte un circuit électronique propre à déclencher une alerte lorsque les valeurs de température mesurées franchissent un seuil déterminé.

En particulier, dans le cas où le capteur de mesure équipe un compteur d'eau, le récepteur comporte un seuil bas de température de déclenchement de l'alerte inférieur à 0°C, pour prévenir un risque de gel.

Le récepteur peut également comporter un seuil haut de température de déclenchement d'alerte, notamment de l'ordre de 60°C, correspondant à la température maximale que la pile ou le capteur lui-même, ou un élément de celui-ci peut supporter.

Un équipement tel que défini précédemment est avantageusement mis en place dans un réseau de distribution de fluide, en particulier d'eau, avec des capteurs installés sur les compteurs de fluide, les émetteurs des capteurs permettant d'assurer une télé-relève de la consommation.

Il est également proposé en exemple, un capteur de mesure autonome, alimenté par une pile électrique, pour un équipement de relevé et de transmission de valeurs mesurées de grandeurs physiques, comprenant un émetteur propre à transmettre à différents instants au moins une valeur mesurée fournie par le capteur, et caractérisé en ce qu' il comporte un moyen de mesure de la température au voisinage de la pile, et une liaison prévue pour fournir à l'émetteur les valeurs de température mesurées, lequel émetteur est prévu pour transmettre, outre les valeurs d'au moins une grandeur physique, ces valeurs de température mesurées, à intervalles déterminés.

L'invention consiste, mises à part les dispositions exposées ci-dessus, en un certain nombre d'autres dispositions dont il sera plus explicitement question ci-après à propos d'un exemple de réalisation décrit avec référence au dessin annexé, mais qui n'est nullement limitatif. Sur ce dessin :
- Fig. 1 est un schéma simplifié d'un équipement de relevé et de transmission de valeurs mesurées de grandeurs physiques, dans le cas d'un compteur d'eau.
Fig. 2 est un schéma simplifié du circuit électronique avec moyen de mesure de la température et émetteur, et
Fig. 3 est un diagramme illustrant des profils de température possibles en fonction du temps.

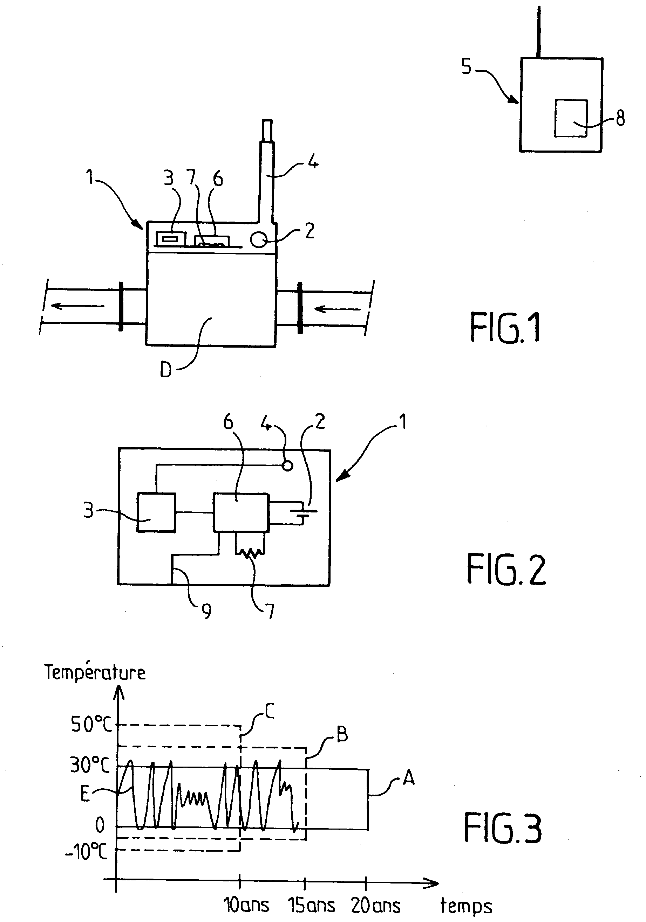

En se reportant à Fig. 1 du dessin, on peut voir, schématiquement représenté, un équipement, ou installation, de relevé et de transmission de valeurs mesurées de grandeurs physiques. Cet équipement comprend au moins un capteur de mesure autonome 1, alimenté par une pile électrique 2, comportant un émetteur 3 avec une antenne 4, propre à émettre par radiofréquence à différents instants au moins une valeur mesurée par le capteur 1. L'équipement comprend en outre un récepteur 5 pour recueillir les valeurs transmises par l'émetteur 3. En variante, l'émetteur 3 pourrait être relié par un dispositif filaire au récepteur 5 et ne comporterait pas d'antenne.

Le capteur de mesure 1 peut être du type décrit dans la demande de brevet déjà citée FR 2 904 688, et être installé sur un compteur d'eau D. Le capteur de mesure 1 comporte un transducteur sensible à la rotation d'un élément métallique et propre à créer des informations numériques correspondant à ladite rotation. Le capteur avec son transducteur est placé contre le compteur d'eau D et les informations numériques, correspondant à la consommation, sont envoyées à un microprocesseur 6 programmé pour traiter ces informations et les communiquer à l'émetteur 3.

Sur le schéma de Fig. 1, un seul capteur 1 a été représenté. Bien entendu, plusieurs capteurs tels que 1, correspondant à plusieurs compteurs D, peuvent être associés à un même récepteur 5 constituant un site central.

De manière générale, l'invention concerne les capteurs au sens large, et plus précisément les compteurs de liquides ou gaz sensibles à la température ambiante (compteurs d'eau par exemple), soit parce que le liquide lui-même est sensible à la température (par exemple le gel pour l'eau), soit parce que le dispositif de comptage y est sensible en raison des technologies employées (température froide pour les cristaux liquides ou les piles, température élevée pour les piles également, ou certains matériaux plastiques).

Le circuit électronique comportant le microprocesseur 6, prévu dans un capteur communiquant, rend possible la lecture et la transmission périodique de la ou des grandeurs physiques considérées, notamment le volume de fluide débité dans le cas d'un comptage de fluide.

Un avantage important de tels capteurs de mesure est qu'ils permettent de réaliser des télé-relevés de consommation, sans qu'il soit nécessaire qu'une personne se déplace périodiquement pour la lecture du compteur. Toutefois, l'autonomie du capteur n'est assurée que si la pile d'alimentation 2 est toujours en vie.

Pour conserver l'équipement en état de fonctionnement, il convient donc d'assurer une maintenance efficace des capteurs 1 et de procéder à leur remplacement avant que la pile d'alimentation 2 n'arrive en fin de vie. Pour éviter une absence de relevé de la ou des grandeurs physiques mesurées pendant une période comprise entre la fin de vie d'une pile et le remplacement du capteur, les fabricants de piles ont tendance à sur-dimensionner les piles et à sous-estimer leur durée de vie probable, tandis que les exploitants ont tendance à remplacer les capteurs bien avant la fin de vie sous-estimée de la pile. Ainsi, les capteurs sont changés plus fréquemment qu'il ne faudrait, ce qui engendre un surcoût d'exploitation.

L'invention prévoit d'adjoindre systématiquement aux données principales fournies par le capteur 1, et directement liées à la fonction primaire de ce capteur, une information secondaire concernant la température ambiante à proximité immédiate du dispositif capteur, afin d'estimer de manière plus précise la durée de vie de la pile.

En outre, une telle disposition permet de générer des alertes en cas de franchissement de seuils de températures prédéfinies, telles que des températures trop basses, entraînant un risque de gel pour un compteur d'eau, ou bien des températures trop élevées, entraînant un risque de détérioration de la pile ou du matériau plastique pour un dispositif capteur par exemple placé en plein soleil dans le sud de l'Europe.

Le capteur de mesure 1 comporte, selon l'invention, un moyen de mesure 7 de la température disposé au voisinage de la pile 2. Ce moyen de mesure 7 peut être constitué par une résistance platine, ou par tout autre moyen de mesure de température connu, approprié pour l'application envisagée. Le moyen de mesure 7 peut être noyé avec la pile 2 et les circuits électroniques dans un enrobage de maintien et/ou de protection, notamment en matière plastique.

Le moyen de mesure 7 peut être branché à des bornes du microprocesseur 6. Une liaison est ainsi établie entre le moyen de mesure 7 et l'émetteur 3. Ce dernier, piloté par le microprocesseur 6, est prévu pour transmettre les valeurs mesurées de température à intervalles déterminés, outre les valeurs de la ou des grandeurs physiques, notamment le volume de fluide débité, auxquelles le capteur est affecté. Quatre mesures de température par jour peuvent être effectuées à des intervalles réguliers, auquel cas les émissions de valeurs mesurées de température auront lieu toutes les six heures.

Le récepteur 5 est prévu pour stocker les valeurs de température, estimer la durée de vie de la pile 2 du capteur considéré, en tenant compte de ces valeurs mesurées, et déterminer une date de remplacement de cette pile. A cet effet, le récepteur 5 comporte une unité de calcul 8, comportant microprocesseur et mémoire, programmée pour effectuer les opérations de stockage des valeurs mesurées et d'estimation de la durée de vie de la pile.

Le microprocesseur 6 du capteur 1 reçoit, traite et communique à l'émetteur 3, d'autres informations que la température au voisinage de la pile, notamment le volume consommé dans le cas d'un compteur de fluide, la pression du fluide ou autre grandeur physique fournies au microprocesseur sur une ou plusieurs liaisons telles que 9.

La systématisation de la mesure secondaire de température peut être réalisée pour un coût marginal réduit car un microprocesseur comporte fréquemment un moyen de mesure de température à des fins de compensation de la dérive de l'horloge interne. En termes de précision de mesure, une tolérance de ± 1°C est tout à fait acceptable, ce qui reste compatible avec des solutions à faible coût, sans nécessiter d'étalonnage particulier.

La mémoire de l'unité de calcul 8 du récepteur 5 peut être chargée de profils de températures types pour la pile, correspondant à une durée de vie hautement probable.

Fig. 3 illustre trois profils types possibles, la température étant portée en ordonnée et le temps en abscisse.

Le profil A correspond à une longue vie : c'est le cas d'une pile exposée à une température moyenne convenable de l'ordre de 15°C, les variations de la température étant comprises, par exemple, entre 0°C et 30°C. La vie de la pile est estimée à 20 ans.

Le profil standard B correspond à une durée de vie moyenne, par exemple, de 15 ans. C'est le cas d'une pile exposée à des températures comprises, par exemple, entre -2°C et 40°C.

Le profil C correspond à une courte vie. C'est le cas d'une pile exposée à des conditions plus sévères de température, entre -10°C et 50°C, par exemple pour des capteurs situés dans des zones de montagne, ou des zones exposées au soleil.

L'unité de calcul 8 stocke les valeurs de température mesurées, établit un profil réel E et le compare aux profils types illustrés sur Fig. 3, et en déduit la durée de vie probable pour la pile. Avec le profil E illustré qui déborde du profil A mais est situé à l'intérieur du profil B, la durée de vie serait estimée celle du profil B, soit 15 ans.

Pour simplifier, on n'a représenté que trois profils types sur Fig. 3, alors qu'il est bien entendu possible d'affiner ces profils types et de tenir compte de la fréquence de dépassement des limites de température d'un profil par les valeurs mesurées.

L'unité de calcul 8 est en outre avantageusement prévue pour déclencher une alerte lorsque les valeurs de température mesurées franchissent un seuil déterminé.

Par exemple, dans le cas d'un compteur d'eau qui peut être détérioré par le gel, lorsque la température indiquée par le capteur 1 est inférieure par exemple à -5°C ou -10°C, l'unité de calcul 8 déclenche l'envoi d'une alerte, de préférence à l'exploitant du réseau, pour faire prévenir l'usager des risques de gel de son compteur d'eau et pour qu'il intervienne afin de vérifier et/ou d'améliorer l'isolation thermique de ce compteur.

De même, dans le cas d'une température élevée, par exemple supérieure à +60°C susceptible de détruire la pile, une alerte est envoyée par l'unité de calcul 8, généralement à l'exploitant du réseau, pour lui indiquer que la pile est en train de subir des conditions thermiques préjudiciables à son bon fonctionnement à terme et qu'il convient de prendre des mesures pour corriger cette surchauffe .

Un premier exemple d'application concret concerne une société distributrice d'eau. L'invention permet d'identifier, en période de grands froids, les compteurs soumis à des températures excessivement basses les rendant susceptibles de geler et donc d'être irrémédiablement détériorés, ce qui entraînerait des fuites importantes et des dégâts des eaux onéreux aussi bien pour l'usager que pour la société distributrice d'eau. Sur la base des informations de température remontées par l'unité de calcul 8, la société distributrice d'eau pourra mettre en place des actions de prévention, par exemple en prévenant les usagers concernés pour les inciter à corriger le problème en installant des dispositifs isolants coiffant les compteurs d'eau.

Un autre exemple d'application concernerait une société distributrice d'eau gérant un parc de capteurs pouvant être soumis en été à des températures excessivement élevées, ayant un impact néfaste sur la durée de vie des piles. Sur cette base, la société distributrice pourra soit tenir compte de ces informations pour corriger la durée de vie espérée des capteurs soumis à ces fortes températures et planifier un remplacement anticipé, soit mettre en place des protections thermiques.

L'invention permet d'améliorer sensiblement la maintenance de capteurs de mesure autonomes. Les coûts d'exploitation d'une installation de distribution avec compteurs équipés de capteurs de télé-relève sont sensiblement réduits.

## Revendications

1. Equipement de relevé et de transmission de valeurs mesurées de grandeurs physiques, comprenant :
- au moins un capteur de mesure autonome (1), alimenté par une pile électrique (2), comportant un émetteur (3) propre à transmettre à différents instants au moins une valeur mesurée par le capteur,
- et un récepteur (5) pour recueillir les valeurs transmises par l'émetteur,
**caractérisé en ce que** :
- le capteur (1) comporte un moyen de mesure (7) de la température au voisinage de la pile (2),
- une liaison est prévue pour fournir à l'émetteur (3) les valeurs de température mesurées, lequel émetteur est prévu pour transmettre, outre les valeurs d'au moins une grandeur physique, ces valeurs de température mesurées, à intervalles déterminés,
- le récepteur (5) est prévu pour stocker les valeurs de température mesurées, estimer la durée de vie de la pile en tenant compte de ces valeurs mesurées, et déterminer une date de remplacement de cette pile.
- et le récepteur (5) est prévu pour établir un profil de température (E) de la pile en fonction du temps, et comporte un moyen de comparaison (8) du profil de température relevé avec des profils types (A,B,C) pour estimer la durée de vie probable de la pile.

2. Equipement selon la revendication 1, **caractérisé en ce que** le récepteur (5) comporte un circuit électronique (8) propre à déclencher une alerte lorsque les valeurs de température mesurées franchissent un seuil déterminé.

3. Equipement selon la revendication 2, avec capteur de mesure équipant un compteur d'eau (D), **caractérisé en ce que** le récepteur (5) comporte un seuil bas de température de déclenchement de l'alerte inférieur à 0°C, pour prévenir un risque de gel.

4. Equipement selon l'une quelconque des revendications 1 à 3, **caractérisé en ce que** le récepteur (5) comporte un seuil haut de température de déclenchement d'alerte correspondant à la température maximale que la pile peut supporter.

5. Equipement selon la revendication 4, **caractérisé en ce que** le seuil haut de température de déclenchement d'alerte est de l'ordre de 60°C.

6. Equipement selon l'une quelconque des revendications 1 à 5, **caractérisé en ce qu'**il est mis en place dans un réseau de distribution de fluide, en particulier d'eau, avec des capteurs (1) installés sur les compteurs de fluide (D), les émetteurs (3) des capteurs permettant d'assurer une télé-relève de la consommation.

## Patentansprüche

1. Ausrüstung zum Aufzeichnen und Übertragen von Messwerten physikalischer Größen, umfassend:
- mindestens einen von einer elektrischen Batterie (2) gespeisten autonomen Messsensor (1), umfassend einen Sender (3) zum Übertragen mindestens eines vom Messsensor gemessenen Werts zu verschiedenen Zeitpunkten,
- und einen Empfänger (5) zum Sammeln der vom Sender übertragenen Werte,
**dadurch gekennzeichnet, dass**:
- der Messsensor (1) ein Messmittel (7) für die Temperatur in der Umgebung der Batterie (2) aufweist,
- eine Verbindung vorgesehen ist, um dem Sender (3) die Temperaturmesswerte bereitzustellen, wobei der Sender so ausgelegt ist, dass er neben den Werten mindestens einer physikalischen Größe auch diese Temperaturmesswerte in vorgegebenen Intervallen überträgt,
- der Empfänger (5) so ausgelegt ist, dass er die Temperaturmesswerte speichert, aus diesen Messwerten die Lebensdauer der Batterie abschätzt und ein Austauschdatum für die Batterie ermittelt,
- und der Empfänger so ausgelegt ist, dass er ein Temperaturprofil (E) der Batterie in Abhängigkeit der Zeit erstellt und ein Mittel zum Vergleich des erhobenen Temperaturprofils mit typischen Profilen (A, B, C) enthält, um eine wahrscheinliche Lebensdauer der Batterie abzuschätzen.

2. Ausrüstung nach Anspruch 1, **dadurch gekennzeichnet, dass** der Empfänger (5) eine elektronische Schaltung (8) umfasst, die in der Lage ist, einen Alarm auszulösen, wenn die Temperaturmesswerte eine festgelegte Schwelle überschreiten.

3. Ausrüstung nach Anspruch 2, mit einer Messsensor, der an einem Wasserzähler (D) angebracht ist, **dadurch gekennzeichnet, dass** der Empfänger (5) eine untere Temperaturschwelle zur Auslösung eines Alarms unterhalb von 0°C aufweist, um eine Einfriergefahr zu verhindern.

4. Ausrüstung nach einem der Ansprüche 1 bis 3, **dadurch gekennzeichnet, dass** der Empfänger (5) eine obere Temperaturschwelle zur Auslösung eines Alarms aufweist, die der maximalen Temperatur entspricht, die die Batterie aushalten kann.

5. Ausrüstung nach Anspruch 4, **dadurch gekennzeichnet, dass** die obere Temperaturschwelle zur Auslösung des Alarms in der Größenordnung von 60°C ist.

6. Ausrüstung nach einem der Ansprüche 1 bis 5, **dadurch gekennzeichnet, dass** sie in einem Fluidverteilungsnetz eingesetzt ist, insbesondere in einem Wasserverteilungsnetz, mit auf den Fluidzählern (D) angeordneten Messsensoren (1), wobei die Sender (3) der Messsensoren es ermöglichen, eine Fernerhebung des Verbrauchs sicherzustellen.

## Claims

1. An item of equipment for logging and transmitting measured values of physical magnitudes, comprising:
- at least one standalone measurement sensor (1), powered by an electric cell (2), comprising a transmitter (3) capable of transmitting at various times at least one value measured by the sensor,
- and a receiver (5) for collecting the values transmitted by the transmitter,
**characterized in that**:
- the sensor (1) comprises a means (7) for measuring the temperature in the vicinity of the cell (2),
- a link is provided to supply to the transmitter (3) the measured temperature values, which transmitter is designed to transmit, in addition to the values of at least one physical magnitude, these measured temperature values, at determined intervals,
- and the receiver (5) is designed to store the measured temperature values, estimate the life of the cell by taking account of these measured values, and determine a date of replacement of this cell,
- the receiver (5) is designed to establish a temperature profile (E) of the cell as a function of time, and comprises a means (8) for comparing the temperature profile that has been logged with typical profiles (A, B, C) in order to estimate the probable life of the cell.

2. The item of equipment as claimed in claim 1, **characterized in that** the receiver (5) comprises an electronic circuit (8) capable of initiating an alarm when the measured temperature values exceed a determined threshold.

3. The item of equipment as claimed in claim 2, with measurement sensor fitted to a water meter (D), **characterized in that** the receiver (5) comprises a low temperature threshold for triggering the alarm below 0°C, in order to warn of a risk of freezing.

4. The item of equipment as claimed in any one of the claims 1 to 3, **characterized in that** the receiver (5) comprises a high temperature threshold for triggering an alarm corresponding to the maximum temperature that the cell can withstand.

5. The item of equipment as claimed in claim 4, **characterized in that** the high temperature threshold for triggering an alarm is of the order of 60°C.

6. The item of equipment as claimed in any one of the claims 1 to 5, **characterized in that** it is installed in a network for the delivery of fluid, in particular of water, with sensors (1) installed on the fluid meters (D), the transmitters (3) of the sensors making it possible to ensure a remote logging of consumption.
